# FASCICULE DE BREVET EUROPEEN

(11) **EP 0 421 533 B1**
(45) Date de publication et mention de la délivrance du brevet: **18.01.1995**
(21) Numéro de dépôt: 90202589.9
(22) Date de dépôt: 01.10.1990
(51) Int. Cl.: H04L 27/36, H03F 1/32, H04B 1/62

(54) **Dispositif de prédistorsion pour système de transmission numérique**
Vorverzerrungseinrichtung für digitale Übertragungsysteme
Predistortion apparatus for a digital transmission system

(30) Priorité: 06.10.1989 FR 8913092
(43) Date de publication de la demande: 10.04.1991
(73) Titulaire: LABORATOIRES D'ELECTRONIQUE PHILIPS, 94453 Limeil-Brévannes Cédex (FR); Philips Electronics N.V., 5621 BA Eindhoven (NL)
(72) Inventeur: Karam, Georges Société Civile S.P.I.D., F-75008 Paris (FR); Moridi, Said Société Civile S.P.I.D., F-75008 Paris (FR)
(74) Mandataire: Landousy, Christian

(56) Documents cités:
- US-A- 4 291 277
- US-A- 4 462 001
- AT & T BELL LABORATORIES TECHNICAL JOURNAL. vol. 62, no. 4, avril 1983, NEW YORK US pages 1019 - 1033;A. A. SALEH and J. SALZ: "Adaptive Linearization or Power Amplifiers in Digital Radio Systems"

## Description

L'invention concerne un dispositif de prédistorsion pour système de transmission numérique qui transmet des données d'entrée complexes d'une constellation à la cadence d'une horloge symbole H de période T, à l'aide d'un modulateur et d'un amplificateur de puissance qui distord les données, le dispositif comprenant un circuit de prédistorsion qui prédistord en sens opposé les données d'entrée avant leur passage dans l'amplificateur afin de transmettre les données d'entrée attendues.

Un tel dispositif de prédistortion fait également l'objet de la demande de brevet EP-A- 0 421 532 déposée le même jour.

L'invention trouve ses applications dans les systèmes de transmission numérique tels que les modems de transmission de données, les faisceaux hertziens, les systèmes de communications spatiales.

Pour une utilisation efficace du spectre disponible, les systèmes de transmission numérique actuels, notamment les faisceaux hertziens et les systèmes de transmission de données sur le canal téléphonique, utilisent des modulations à grands nombres d'états de phase et d'amplitude. Or ces modulations sont très sensibles à toute sorte de distorsion, et bien entendu, aux distorsions non linéaires provenant des amplificateurs, des mélangeurs et d'autres circuits non-linéaires de la chaîne de transmission. Un point particulièrement critique en faisceaux hertziens et en transmission par satellite est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre le rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états (MAQ64 et MAQ256 par exemple), ce point est loin de la puissance de saturation de l'amplificateur, ce qui signifie que celui-ci n'est pas utilisé d'une façon efficace. Pour augmenter son efficacité, on utilise couramment des techniques de prédistorsion (fixe ou adaptative) qui permettent de réduire l'effet de la non-linéarité de l'amplificateur de puissance sur le signal émis.

Une technique de prédistorsion couramment utilisée consiste à placer à l'étage de fréquence intermédiaire de l'émetteur un circuit non-linéaire approchant la fonction inverse de l'amplificateur de puissance dont on vise à compenser les non-linéarités. Si l'on savait synthétiser l'inverse exact de la fonction de l'amplificateur, cette technique permettrait d'avoir un signal parfait en sortie (sans aucune distorsion non-linéaire). Toutefois, ceci n'est pas réalisable, car l'inverse exact nécessiterait un circuit de complexité infinie. En pratique, on se contente de faire une approximation et le plus souvent on limite à l'ordre 3 la série de Taylor représentant la fonction non-linéaire de l'amplificateur et on synthétise un circuit de prédistorsion, également d'ordre 3, tel que les deux circuits cascadés n'aient plus de distorsion d'ordre 3. Des termes d'ordres supérieurs (ordre 5 et ordre 7) apparaissent en sortie mais de faible amplitude comparés à la distorsion d'ordre 3 initiale. Il en résulte ainsi une certaine amélioration des performances du système. Un inconvénient de ces circuits de prédistorsion à l'étage de fréquence intermédiaire réside dans le fait que ce sont des circuits analogiques. Ils sont difficiles à rendre adaptatifs et nécessitent de temps à autre une intervention pour les réajuster et compenser les variations de la réponse de l'amplificateur avec le temps et avec la température. Cette technique de prédistorsion est en outre à exclure si l'on veut faire une commande automatique de puissance d'émission.

Une autre technique de prédistorsion, plus récente, consiste à modifier l'alphabet des données à émettre. Cette technique appelée "prédistorsion de données" ou "prédistorsion en bande de base" est connue du document US-A- 4 291 277 et de l'article de A.A.M. SALEH et J. SALZ "Adaptive linearization of power amplifiers in digital radio systems" Bell System Technical Journal Vol. 62 Avril 1983, pages 1019-1033.

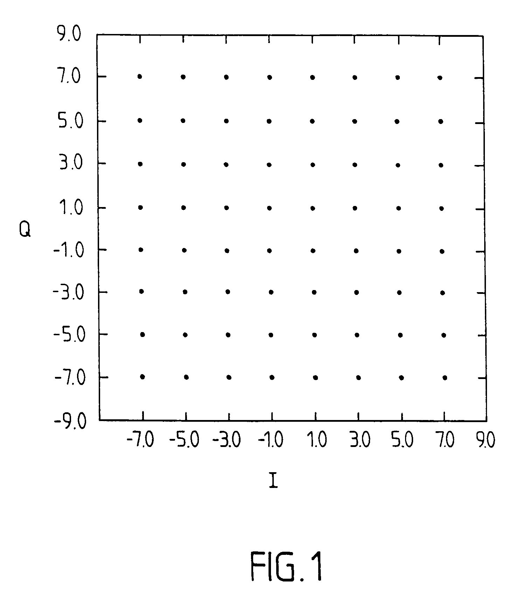

Dans l'article de A.A.M. SALEH et J. SALZ, la figure 1 est un schéma d'un circuit de prédistorsion adaptative qui fournit à l'entrée du modulateur une constellation distordue à partir de la constellation carrée d'origine, par exemple d'une modulation d'amplitude de deux porteuses en quadrature MAQ. L'amplificateur agit sur la constellation en produisant une nette compression et une nette rotation des points de grande amplitude. Pour compenser cet effet, la constellation d'origine est distordue de sorte qu'elle reprend sa forme carrée originelle après son passage dans l'amplificateur de puissance. Ainsi, lorsque le circuit de prédistorsion est optimisé, il forme l'inverse de l'amplificateur de puissance (à un gain et à une phase près) et permet de compenser parfaitement les non-linéarités de l'amplificateur. Pour rendre ce circuit adaptatif, le signal est repris à la sortie de l'amplificateur, démodulé, puis échantillonné à la cadence d'émission des symboles 1/T et on compare ces échantillons au point correspondant de la constellation MAQ utilisée. Ces comparaisons permettent d'obtenir un signal de commande permettant d'optimiser le circuit de prédistorsion à l'aide d'un algorithme classique. Toutefois, le schéma utilisé sur cette figure 1 est très simpliste, car il ne dispose d'aucun filtrage avant le modulateur, ni avant l'amplificateur de puissance. Il ne correspond donc pas à la solution généralement utilisée. En effet dans les systèmes réels, on utilise toujours un filtrage de mise en forme spectrale de type Nyquist permettant de limiter la bande du signal tout en garantissant une interférence intersymbole nulle aux instants de décision. Ce filtrage est en général partagé équitablement entre l'émission et la réception pour maximiser le rapport signal à bruit également aux instants de décision. Dans de tels systèmes, l'effet de la non-linéarité de l'amplificateur est double : la constellation est non seulement déformée mais il apparaît une interférence intersymbole qui associe à chaque point de la constellation un nuage de points. Or, la technique de prédistorsion décrite ci-dessus ne permet pas de compenser ce deuxième effet.

Le problème posé est donc de réaliser un circuit de prédistorsion qui permette non seulement de corriger la constellation mais aussi de réduire considérablement la dispersion de chaque point de la constellation d'origine en un nuage de points.

Ce but doit être atteint en réduisant au maximum la complexité et la quantité de matériel nécessaire.

La solution à ce problème consiste en ce que le dispositif de prédistorsion comprend un filtre d'émission qui, à partir des données d'entrée, délivre, à la cadence k/T (où k est un entier supérieur à 1), des données filtrées suréchantillonnées codées sur 2N bits (N bits par voie) au circuit de prédistorsion qui comprend :
- un codeur qui transforme les données filtrées codées sur 2N bits en données codées sur 2M bits (M<N),
- une mémoire adressée par les 2M bits, qui stocke 2^{2M} coefficients de prédistorsion complexes,
- un multiplieur complexe qui multiplie, pour chaque donnée, les 2N bits de la donnée filtrée par le coefficient de prédistorsion sélectionné pour délivrer des données prédistordues (F_{I},F_{Q}).

Le filtre d'émission effectue une mise en forme spectrale qui est complétée par un filtrage de réception de telle sorte que le filtrage global émission-réception soit un filtre de Nyquist permettant ainsi de garantir une interférence intersymbole nulle aux instants de décision. Pour diminuer la taille des nuages de points il est nécessaire d'opérer une correction avec plus d'un échantillon par durée symbole T.

Ainsi avantageusement la détermination en cascade des coefficients de prédistorsion puis des données prédistordues (F_{I},F_{Q}) ne nécessite qu'un matériel réduit, comparé à une détermination à l'aide des champs complets de 2 N bits. Ceci est particulièrement sensible lorsque le circuit de prédistorsion utilise une mémoire. En opérant selon l'invention la taille de la mémoire est considérablement diminuée.

Le codeur peut sélectionner les 2M bits de poids forts des 2N bits des données filtrées.

Mais la fonction mise en oeuvre par le codeur peut être plus complexe. Ainsi pour chaque coordonnée (r,q), codée sur N bits, se rapportant aux voies en phase et en quadrature, le codeur peut déterminer le module (r²+q²) et le coder sur 2M bits.

Le filtre d'émission, placé avant le codeur, qui délivre les données suréchantillonnées codées sur 2N bits peut être soit un filtre numérique soit un filtre analogique suivi d'un convertisseur analogique-numérique.

L'invention vient d'être décrite pour un système muni d'un circuit de prédistorsion fixe. Il existe en effet des situations ou les mécanismes de distorsion sont relativement stables ou pour lesquelles une correction parfaite n'est pas recherchée. Mais généralement les mécanismes de distorsion sont évolutifs et il est alors nécessaire de les corriger en permanence. Dans ce cas le circuit de prédistorsion est adaptatif et pour cela comprend un circuit d'adaptation qui à partir d'une démodulation du flux de données transmises adapte continûment le circuit de prédistorsion à partir d'une comparaison des données d'entrée et des données transmises. L'écart observé sert à corriger les coefficients de prédistorsion qui sont stockés en mémoire et qui sont régulièrement mis à jour.

L'invention sera mieux comprise à l'aide des figures suivantes données à titre d'exemples non limitatifs et qui représentent :

figure 1 : la constellation d'une modulation MAQ64.

figure 2A : une constellation MAQ64 distordue par l'amplificateur de puissance dans un système sans filtrage ou dans le cas ou tout le filtrage de Nyquist est effectué après l'étage de l'amplificateur.

figure 2B : une constellation prédistordue optimisée pour compenser la distorsion illustrée sur la figure 2A selon l'art antérieur.

figure 3A : la constellation distordue par l'amplificateur telle qu'elle apparaît lorsque le filtrage global est équitablement partagé entre l'émission et la réception et la partie à l'émission est placée avant l'amplificateur.

figure 3B : avec la même situation que celle de la figure 3A, mais en incorporant le circuit de prédistorsion de l'art antérieur.

figure 4 : un schéma d'un système de transmision numérique selon l'invention.

figure 5 : un schéma d'un circuit de prédistorsion selon l'invention.

figure 6 : un schéma d'un système de transmission numérique muni d'un circuit de prédistorsion adaptatif selon l'invention.

La figure 1 est un rappel de la représentation de la constellation d'un signal de type MAQ64. Les entrées I (en phase) et Q (en quadrature) du modulateur sont indépendantes et les symboles sur chaque voie prennent leurs valeurs dans un alphabet (±d, ±3d, ±5d, ±7d).

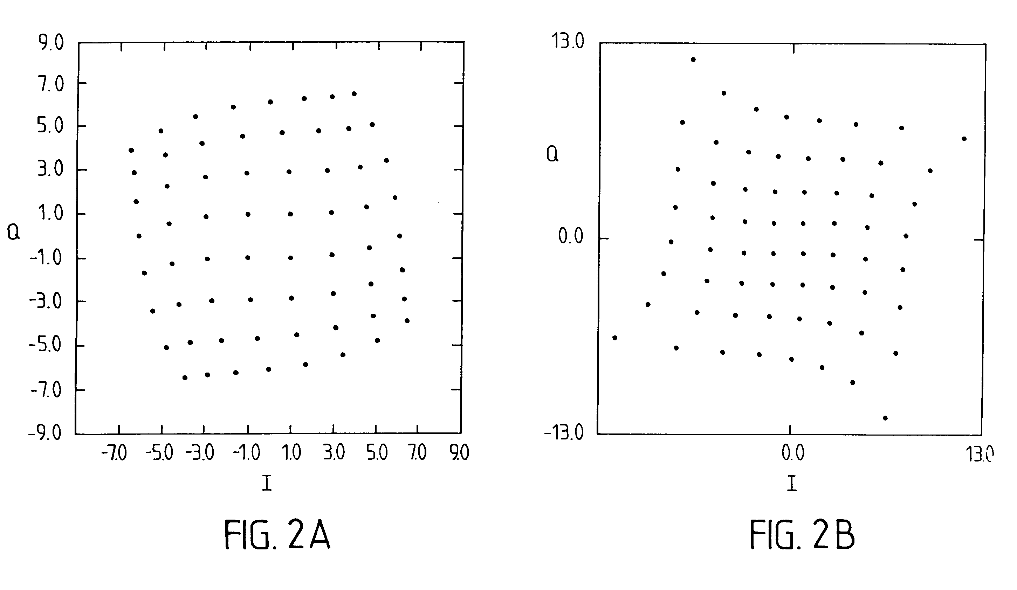

Pour être transmis le signal issu du modulateur est introduit dans un amplificateur de puissance qui est généralement utilisé à puissance réduite, c'est-à-dire dans une partie linéaire de sa caractéristique. A forte puissance cet amplificateur est non-linéaire et distord le signal de manière inacceptable. Si l'on observe une constellation de type MAQ64 à la sortie d'un tel amplificateur opérant proche de la saturation, on observe une constellation distordue comme celle représentée sur la figure 2A. Selon l'art antérieur il suffit alors de prédistordre dans le sens opposé la constellation selon le schéma de la figure 2B pour que en sortie de l'amplificateur on obtienne la constellation d'origine non déformée. Or une situation aussi simple n'est pas conforme à la réalité où il existe toujours un filtrage avant l'amplificateur de puissance notamment pour limiter la bande du signal. En absence de filtrage, le signal à l'entrée du modulateur varie par paliers une fois par durée symbole T. Ainsi, un circuit de prédistorsion agissant sur le signal à cadence 1/T permet une compensation parfaite. Par contre, lorsque le signal est filtré, il ne varie plus par paliers mais d'une façon continue. Pour une compensation parfaite de l'effet de la non-linéarité, il ne suffit plus d'observer le signal une fois par durée symbole T et de compenser la distorsion à ces moments là.

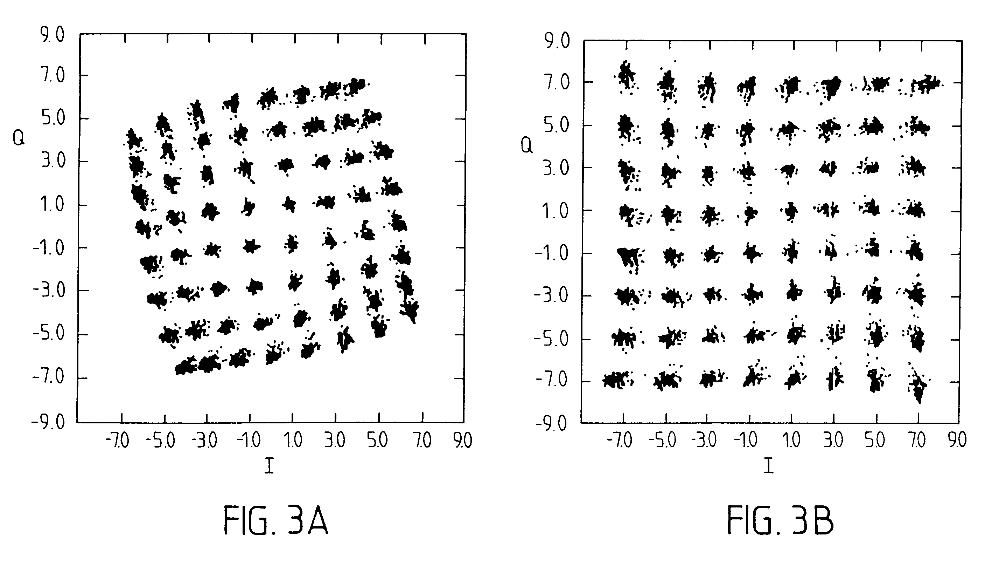

En présence d'un signal filtré la constellation à la sortie de l'amplificateur est représentée sur la figure 3A. Elle devient telle que représentée sur la figure 3B avec le circuit de prédistorsion de l'art antérieur. Ainsi chaque point de la constellation devient un nuage de points ce qui est inacceptable. Pour opérer avec un signal filtré il faut donc opérer la correction à plus d'un point par durée symbole. Pour cela on réalise la mise en forme spectrale d'émission par un filtre numérique délivrant à sa sortie les données filtrées à la cadence k/T (k≧2). Dans le cas où cette mise en forme est réalisée par un filtre analogique, on échantillonne le signal sortant du filtre à la cadence k/T. On dispose ainsi tous les T/k des échantillons du signal filtré que l'on peut prédistordre.

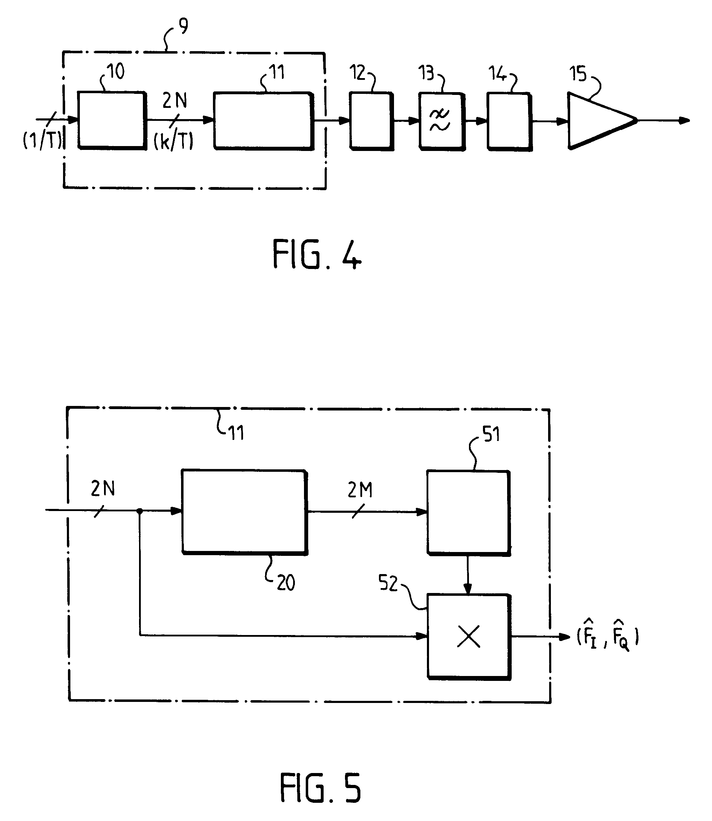

La figure 4 représente un système de transmission numérique avec un dispositif de prédistorsion 9 muni d'un filtre d'émission 10 qui délivre des échantillons, codés sur N bits par voie, à la cadence k/T (k entier au moins égal à 2), et d'un circuit de prédistorsion 11 suivi d'un convertisseur numérique-analogique 12, d'un filtre analogique 13, d'un modulateur 14 et de l'amplificateur 15. C'est cet amplificateur qui distord les données qu'il a à transmettre à l'antenne d'émission.

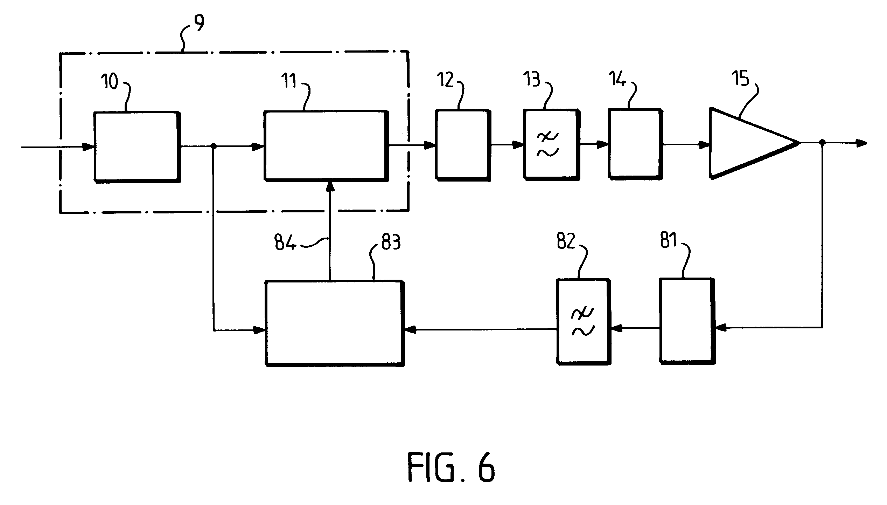

La figure 5 représente un exemple d'un schéma du circuit de prédistorsion 11. Il comprend un codeur 20 qui réduit le codage sur 2N bits en un codage sur 2M bits. Ainsi par exemple pour une modulation MAQ 256 le nombre N=10 bits peut être réduit à M=4 ou 5 bits. Ceci réduit considérablement la taille de la mémoire 51 qui est adressée par les 2M bits. Cette mémoire 51 stocke des coefficients de prédistorsion complexes relatifs à chaque point de la constellation. Ces coefficients de prédistorsion complexes servent dans un multiplieur 52 à multiplier les données filtrées codées sur 2N bits. On obtient ainsi en sortie les données prédistordues (F̂_{I},F̂_{Q}) qui peuvent être transmises par les organes déjà décrits sur la figure 4.

Le codeur 20 peut, dans chaque champ de N bits des voies en phase et en quadrature, sélectionner les M bits de poids forts pour adresser la mémoire 51 avec les 2M bits.

Le codeur 20 peut aussi opérer une fonction plus complexe. Une donnée codée sur 2 N bits peut être représentée par ses coordonnées r et q se rapportant aux voies en phase et en quadrature. Le codeur 20 peut ainsi calculer le module r²+q² propre à cette donnée et la coder sur 2M bits. Ceci est intéressant car les distorsions dépendent beaucoup des variations du module des points. D'autres fonctions peuvent également être envisagées par l'homme du métier pour déterminer les coefficients de prédistorsion à appliquer.

Le schéma de la figure 4 représente un système de transmission qui permet de prédistordre les données et de corriger les distorsions apportées par l'amplificateur dans le cas d'une structure fixe. Mais il est également possible de réaliser une structure adaptative. Ceci est représenté sur le schéma de la figure 6. Les mêmes éléments que ceux de la figure 4 seront représentés avec les mêmes repères. Dans ce cas on prélève le signal de sortie de l'amplificateur 15 pour l'introduire dans un démodulateur 81 suivi d'un filtre passe-bas 82 dont la sortie entre dans un circuit d'adaptation 83. Celui-ci échantillonne le signal de sortie du filtre 82 et compare ces données aux données d'entrée. L'écart donne naissance à un signal d'erreur qui permet (connexion 84) de mettre à jour le circuit de prédistorsion 11 par exemple en stockant dans la mémoire des nouveaux coefficients de prédistorsion complexes.

## Revendications

1. Dispositif de prédistorsion (9) pour système de transmission numérique qui transmet des données d'entrée complexes d'une constellation à la cadence d'une horloge symbole H de période T, à l'aide d'un modulateur (14) et d'un amplificateur de puissance (15) qui distord les données, le dispositif comprenant un circuit de prédistorsion (11) qui prédistord en sens opposé les données d'entrée avant leur passage dans l'amplificateur afin de transmettre les données d'entrée attendues, caractérisé en ce qu'il comprend un filtre d'émission (10) qui, à partir des données d'entrée, délivre, à la cadence k/T (où k est un entier supérieur à 1), des données filtrées suréchantillonnées codées sur 2N bits (N bits par voie) au circuit de prédistorsion (11) qui comprend :
- un codeur (20) qui transforme les données filtrées codées sur 2N bits en données codées sur 2M bits (M<N),
- une mémoire adressée (51) par les 2M bits, qui stocke 2^{2M} coefficients de prédistorsion complexes,
- un multiplieur complexe (52) qui multiplie, pour chaque donnée, les 2N bits de la donnée filtrée par le coefficient de prédistorsion sélectionné pour délivrer des données prédistordues (F_{I},F_{Q}).

2. Dispositif selon la revendication 1 caractérisé en ce que le codeur (20) sélectionne les 2M bits de poids forts des 2N bits des données filtrées.

3. Dispositif selon la revendication 1 caractérisé en ce que pour chaque coordonnée (r,q), codée sur N bits, se rapportant aux voies en phase et en quadrature, le codeur (20) détermine le module (r²+q²) et le code sur 2M bits.

4. Dispositif selon une des revendications 1 à 3 caractérisé en ce que le filtre d'émission (10) est soit un filtre numérique soit un filtre analogique suivi d'un convertisseur analogique/numérique.

5. Dispositif selon une des revendications 1 à 4 caractérisé en ce que le circuit de prédistorsion (11) est adaptatif et pour cela comprend un circuit d'adaptation (83) qui à partir d'une démodulation du flux de données transmises adapte continûment le circuit de prédistorsion à partir d'une comparaison de données d'entrée et des données transmises.

## Patentansprüche

1. Vorverzerrungseinrichtung (9) für ein digitales Übertragungssystem, das komplexe Eingangsdaten einer Konfiguration im Zyklus eines Zeichentaktgebers H der Periode T mittels eines Modulators (14) und eines Leistungsverstärkers (15), der die Daten verzerrt, überträgt, wobei die Einrichtung eine Vorverzerrungsschaltung (11) umfaßt, die die Eingangsdaten in entgegengesetzter Richtung vor ihrem Eintritt in den Verstärker vorverzerrt, um die erwarteten Eingangsdaten zu übertragen, dadurch gekennzeichnet, daß sie einen Sendefilter (10) umfaßt, der aus den Eingangsdaten im Takt k/T (mit k = ganzzahlig größer 1) gefilterte, überabgetastete, auf 2N Bits (N Bits pro Strecke) codierte Daten an die Vorverzerrungsschaltung (11) ausgibt, die:
- einen Codierer (20), der die gefilterten, auf 2N Bits codierten Daten in auf 2M Bits (M<N) codierte Daten umwandelt,
- einen durch die 2M Bits adressierten Speicher (51), der 2^{2M} komplexe Vorverzerrungskoeffizienten speichert,
- einen komplexen Multiplizierer (52), der für alle Daten die 2N Bits der gefilterten Daten mit dem gewählten Vorverzerrungskoeffizienten multipliziert, so daß man vorverzerrte Daten (F_{I}, F_{Q}) erhält, umfaßt.

2. Einrichtung nach Anspruch 1, dadurch gekennzeichnet, daß der Codierer (20) die höherwertigen 2M Bits der 2N Bits gefilterter Daten auswählt.

3. Einrichtung nach Anspruch 1, dadurch gekennzeichnet, daß der Codierer (20) für jede Koordinate (r,q), die auf N Bits codiert ist und sich auf die gleichphasigen und um 90° phasenverschobenenen Strecken bezieht, das Modul (r²+q²) bestimmt und es auf 2M Bits codiert.

4. Einrichtung nach einem der Ansprüche 1 bis 3, dadurch gekennzeichnet, daß der Sendefilter (10) entweder ein digitaler oder ein analoger Filter mit nachgeschaltetem Analog-Digital-Umsetzer ist.

5. Einrichtung nach einem der Ansprüche 1 bis 4, dadurch gekennzeichnet, daß die Vorverzerrungsschaltung (11) adaptiv ist und hierzu eine Anpassungsschaltung (83) umfaßt, die anhand einer Demodulation des übertragenen Datenstroms die Vorverzerrungsschaltung anhand eines Vergleichs der Eingangsdaten und der übertragenen Daten kontinuierlich anpaßt.

## Claims

1. Predistortion arrangement (9) for a digital transmission system which transmits complex input data at the rate of a symbol clock H having a period T, with the aid of a modulator (14) and a power amplifier (15) which distorts the data, the arrangement comprising a predistortion circuit (11) predistorting in opposite sense the input data before they pass through the amplifier in order to transmit the expected input data, characterized in that the predistortion arrangement comprises a transmit filter (10) which applies filtered, oversampled data encoded with 2N bits (N bits per channel) to the predistortion circuit (11) at the rate k/T (where k is an integer greater than 1) in response to the input data, which predistortion circuit (11) includes:
- an encoder (20) transforming the filtered data encoded with 2N bits into data encoded with 2M bits (M < N),
- a memory (51) addressed by the 2M bits, which stores 2^{2M} complex predistortion coefficients,
- a complex multiplier (52) multiplying for each data element the 2N bits of the filtered data element by the selected predistortion coefficient to produce predistorted data (F_{I}, F_{Q}).

2. Arrangement as claimed in Claim 1, characterized in that the encoder (20) selects the 2M most significant bits from the 2N bits of the filtered data.

3. Arrangement as claimed in Claim 1, characterized in that for each N-bit encoded coordinate (r, q) relating to the in-phase and quadrature channels, the encoder (20) determines the modulus (r²+q²) and encodes it with 2M bits.

4. Arrangement as claimed in one of the Claims 1 to 3, characterized in that the transmit filter (10) is either a digital filter or an analog filter followed by an analog-to-digital converter.

5. Arrangement as claimed in one of the Claims 1 to 4, characterized in that the predistortion circuit (11) is adaptive and therefore comprises an adaptation circuit (83) which continuously adapts the predistortion circuit in response to a comparison of the input data and the transmitted data, by means of a demodulation of the transmitted data stream.
